# EUROPÄISCHE PATENTSCHRIFT

(11) **EP 1 532 692 B1**
(45) Veröffentlichungstag und Bekanntmachung des Hinweises auf die Patenterteilung: **09.11.2011**
(21) Anmeldenummer: 03790701.1
(22) Anmeldetag: 08.08.2003
(51) Int. Cl.: H01L 31/0224, H01L 31/0232

(54) **SENSORANORDNUNG ZUM ERFASSEN EINER STRAHLUNG, COMPUTERTOMOGRAPH MIT DIESER SENSORANORDNUNG UND ZUGEHÖRIGES HERSTELLUNGSVERFAHREN**
SENSOR ARRANGEMENT FOR RECORDING A RADIATION, COMPUTER TOMOGRAPH COMPRISING SAID SENSOR ARRANGEMENT AND CORRESPONDING PRODUCTION METHOD
DISPOSITIF DE DETECTION POUR DETECTER UN RAYONNEMENT, TOMOGRAPHE INFORMATIQUE EQUIPE DE CE DISPOSITIF DE DETECTION ET PROCEDE DE REALISATION CORRESPONDANT

(30) Priorität: 28.08.2002 DE 10239506
(43) Veröffentlichungstag der Anmeldung: 25.05.2005
(73) Patentinhaber: Infineon Technologies AG, 85579 Neubiberg (DE)
(72) Erfinder: KUHLMANN, Werner, 81541 München (DE)
(74) Vertreter: Kindermann, Peter
(86) Internationale Anmeldenummer: PCT/DE2003/002675
(87) Internationale Veröffentlichungsnummer: WO 2004/021456

(56) Entgegenhaltungen:
- US-A- 4 940 901
- US-A- 4 982 096
- DREWERY J S ET AL: "AMORPHOUS SILICON PIXEL ARRAYS" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. A310, Nr. 1 / 2, 1. Dezember 1991 (1991-12-01), Seiten 165-170, XP000274749 ISSN: 0168-9002

## Beschreibung

Sensoranordnung zum Erfassen einer Strahlung, Computertomograph mit dieser Sensoranordnung und zugehöriges Herstellungsverfahren

Die Erfindung betrifft eine Sensoranordnung zum Erfassen einer Strahlung, insbesondere einer Röntgenstrahlung. Die Sensoranordnung enthält eine Vielzahl von Erfassungselementen. Solche Sensoranordnungen werden beispielsweise in Computertomographen oder Einrichtungen zum Durchstrahlen von Gepäckstücken im Flughafenbereich bis hin zum Durchstrahlen von Containern oder ganzen LKW an Grenzkontrollstellen verwendet. Als strahlungsempfindliche Sensoren enthält die Sensoranordnung beispielsweise eine pin-Diode.

Eine pin-Diode ist eine Diode mit einer Schichtenfolge p, i und n, wobei p einen hoch p-dotierten Bereich, i einen eigenleitenden bzw. intrinsischen oder auch nur schwach n- bzw. p-dotierten Bereich und n einen hoch n-dotierten Bereich bezeichnen. Von einem pn-Übergang unterscheidet sich der pin-Übergang vor allem durch den intrinsischen bzw. den schwach dotierten Zwischenbereich. Weil der Sperrstrom der pin-Diode hauptsächlich von der Ladungsgeneration in der i-Zone abhängt, findet diese Diode Anwendung als pin-Photodiode oder als Strahlungsdetektor, zum Beispiel in der Kerntechnik. In einem Computertomographen wird die Röntgenstrahlung beispielsweise mit Hilfe einer sogenannten Szintillator-Schicht in einem mit Hilfe der pin-Diode erfassbare Strahlung umgewandet, beispielsweise in sichtbares Licht, insbesondere in Licht in einem Wellenlängenbereich von fünfhundert bis siebenhundert Nanometern. Licht in diesem Wellenlängenbereich läßt sich beispielsweise von Silizium mit einem hohen Wirkungsgrad detektieren.

Aus der US 5,581,084 ist ein Infrarotdetektor bekannt zum simultanen erfassen von zwei Farben. Der Infrarotdetektor hat eine Metallkontakt an einer mittleren Schicht.

Es ist Aufgabe der Erfindung zum Erfassen einer Strahlung eine einfach aufgebaute Sensoranordnung anzugeben, die insbesondere mit halbleitertechnischen Standardverfahren hergestellt werden kann, die mit geringen Kosten hergestellt werden kann und die mit einer hohen Ausbeute hergestellt werden kann. Außerdem sollen ein Computertomograph mit einer solchen Sensoranordnung und ein zugehöriges Herstellungsverfahren angegeben werden.

Die auf die Sensoranordnung bezogene Aufgabe wird durch eine Sensoranordnung mit den im Patentanspruch 1 angegebenen Merkmalen erfüllt. Weiterbildungen sind in den Unteransprüchen angegeben.

Die erfindungsgemäße Sensoranordnung mit den im Patentanspruch 1 angegebenen Merkmalen enthält in der genannten Reihenfolge, beispielsweise von oben nach unten:
- ein Haltesubstrat, das zumindest bereichsweise für die zu erfassende Strahlung durchlässig ist oder beim Auftreffen einer Strahlung eine zu erfassende Strahlung erzeugt und dass mehrere Erfassungselemente der Sensoranordnung hält,
- mindestens eine Hilfsschicht, die für die zu erfassende Strahlung durchlässig ist und die sich durchgehend über mehrere Erfassungselemente erstreckt oder die voneinander getrennte Bereiche enthält, die jeweils einem Erfassungselement zugeordnet sind,
- eine Erfassungsschicht mit voneinander getrennten und in einem Erfassungselement enthaltenen Erfassungsbereichen, in denen jeweils mindestens ein für die zu erfassende Strahlung sensitives Halbleiterbauelement anordnet ist, und
- eine Isolierschicht mit von einander getrennten Isolierbereichen zum elektrischen Isolieren der Erfassungsbereichen von einer Kontaktierungslage mit elektrisch leitfähigen Anschlüssen.

Die Erfindung geht von der Überlegung aus, dass sich eine Sensoranordnung mit Schichtenfolgen auf einfache Art herstellen läßt. Insbesondere läßt sich der Herstellungsprozeß so gestalten, dass die Erfassungselemente nie voneinander mechanisch getrennt werden müssen, was deren Handhabbarkeit erheblich erschweren würde. Das Haltesubstrat und die Hilfsschicht gewährleisten, daß die Erfassungselemente während des gesamten Herstellungsprozesses miteinander mechanisch verbunden bleiben. Die Hilfsschicht erfüllt diese Aufgabe bis zum Anbringen des Haltesubstrates. Ist das Haltesubstrat angebracht worden, kann auch die Hilfsschicht getrennt werden.

Bei einer Ausgestaltung liegen die Schichten der Schichtenfolge in zueinander parallelen Ebenen. Durch diese Maßnahme lassen sich Haltesubstrate, Hilfsschichten, Erfassungsschichten und Isolierschichten mit ebenen Flächen für die Herstellung der Sensoranordnung nutzen.

Bei einer Weiterbildung der Sensoranordnung enthält das Haltesubstrat für die zu erfassende Strahlung durchlässige Bereiche als Bestandteil der Erfassungselemente und zu erfassende strahlungsabsorbierende Bereiche zwischen den Erfassungselementen. Durch diese Maßnahme wird gewährleistet, daß die zu erfassende Strahlung nur zu einem Erfassungselement gelangt.

Bei der Erfindung enthält das Haltesubstrat ein Material, das eine auf das Material auftreffende Teilchenstrahlung oder eine im Vergleich zu der zu erfassenden Strahlung energiereiche Strahlung in die zu erfassende Strahlung umwandelt. So läßt sich insbesondere eine Röntgenstrahlung in eine Strahlung umwandeln, die mit Hilfe eines Halbleiterbauelementes mit hohem Wirkungsgrad erfasst werden kann. Solche Materialien werden auch als Szintillator bezeichnet. Geeignet ist beispielsweise GaO-Sulfid.

Bei einer anderen Weiterbildung der Sensoranordnung sind Bereiche der Hilfsschicht durch ein Füllmaterial getrennt. Durch diese Maßnahme wird ebenfalls gewährleistet, daß die Strahlung nur auf ein Erfassungselement trifft. Ein Übersprechen wird durch eine geeignete Wahl des Füllmaterials vermieden. Erstreckt sich das Füllmaterial auch zwischen die Erfassungsbereiche und die Isolierbereiche, so erhöht sich die mechanische Stabilität der gesamten Sensoranordnung beträchtlich. Als Füllmaterial wird bei einer nächsten Weiterbildung ein Material mit einem hohen Reflexionsgrad verwendet, beispielsweise Titandioxid.

Bei einer nächsten Weiterbildung ist die Hilfsschicht eine Glasschicht. Alternativ oder zusätzlich ist auch die Isolierschicht eine Glasschicht. Durch die Verwendung von Glas läßt sich der Herstellungsprozeß auf einfache Art durchführen, weil Glas ein Material ist, das ähnliche Materialeigenschaften hat, wie die bei der Halbleitertechnik verwendeten Materialien. Insbesondere lässt sich der thermische Ausdehnungskoeffizient an den von Silizium oder anderen Halbleitern anpassen.

Bei einer nächsten Weiterbildung enthält die Erfassungsschicht ein Halbleiterträgermaterial, beispielsweise ein Siliziummaterial. Das Halbleiterträgermaterial ist beispielsweise eine gedünnte Siliziumscheibe, d.h. ein sogenannter Wafer.

Bei einer nächsten Weiterbildung enthält die Kontaktierungslage Lötmaterial. Damit kann zum Kontaktieren der Sensoranordnung zu einem integrierten Schaltkreis, der eine ausgewählte Schaltung enthält, eine sogenannte Plättchen-Schnellmontage-Technik eingesetzt werden, die auch als Flip-Chip-Technik bezeichnet wird. Jedoch können auch andere Kontaktierungsarten verwendet werden.

Bei einer nächsten Weiterbildung ist die Erfassungsfläche der Erfassungselemente jeweils kleiner als fünf Quadratmillimeter oder kleiner als ein Quadratmillimeter. Durch diese Maßnahme erhöht sich die Auflösung der bildgebenden Systeme im Vergleich zu bisher üblichen Auflösungen beträchtlich. Hierbei wird unter Auflösung die Anzahl von Bildpunkten bezogen auf eine bestimmte Bezugseinheit verstanden. International üblich ist als Bezugseinheit ein Inch (25,4 Millimeter). Die Sensoranordnung enthält bei einer Ausgestaltung mehr als zweihundert Erfassungselemente, beispielsweise mehr als fünfhundert.

Bei einer anderen Weiterbildung wird ein strahlungsempfindliches Halbleiterbauelement einer pin-Diode in jedem Sensorelement eingesetzt. Die Diode enthält eine pin-Schichtenfolge. Die Anschlüsse der Diode werden entweder nur zu einer Seite eines Trägersubstrates geführt. Jedoch werden auch pin-Dioden eingesetzt, die Anschlüsse auf beiden Seiten des Trägersubstrates haben.

Gemäß einem weiteren Aspekt der Erfindung wird ein Computertomograph angegeben, der die erfindungsgemäße Sensoranordnung oder eine ihrer Weiterbildungen enthält. Durch den Einsatz der Sensoranordnung in einem Computertomograph zur Untersuchung von menschlichem oder tierischem Gewebe läßt sich die Leistungsfähigkeit des Computertomographen erheblich verbessern, insbesondere hinsichtlich der Auflösung.

Die Erfindung betrifft außerdem ein Verfahren mit den im Patentanspruch 9 angegebenen Merkmalen zum Herstellen einer Sensoranordnung, bei dem die folgenden Schritte ausgeführt werden:
- Herstellen einer Vielzahl integrierter strahlungsempfindlicher Halbleiterbauelemente ausgehend von einem Trägersubstrat aus Halbleitermaterial einer Ausgangsdicke,
- mechanisches Verbinden des Trägersubstrats und eines Hilfssubstrats an einer Seite des Trägersubstrats, welche strahlungsempfindliche Flächen der Halbleiterbauelemente enthält,
- Dünnen des Trägersubstrats an der freiliegenden Seite auf eine Dicke, die kleiner als die Ausgangsdicke ist,
- mechanisches Verbinden der freien Seite des Trägersubstrats mit einem Isoliersubstrat,
- Anbringen von Anschlussflächen an der freien Seite des Isoliersubstrats,
- Trennen des Isoliersubstrats an den Grenzen einzelner Halbleiterplättchen mit einer Vielzahl von Halbleiterbauelementen und/oder an den Grenzen einzelner Halbleiterbauelemente, wobei das Hilfssubstrat nicht getrennt wird,
- elektrisches Verbinden der Anschlussflächen mit Anschlussstellen, die zu den Halbleiterbauelementen führen,
- mechanisches Verbinden des Hilfssubstrates und eines Haltesubstrates an der freiliegenden Seite des Hilfssubstrates, wobei des Haltesubstrat eine auftreffende Teilchenstrahlung oder eine im Vergleich zu einer zu erfassenden Strahlung energiereiche Strahlung in die zu erfassende Strahlung umwandelt.
- Trennen des Hilfssubstrates an den Grenzen einzelner Halbleiterplättchen und/oder einzelner Halbleiterbauelemente, wobei das Hilfssubstrat nicht getrennt wird.

Das erfindungsgemäße Verfahren ermöglicht bei einer Ausgestaltung die Herstellung von Röntgen-Sensoranordnungen, die pin-Dioden enthalten, mit einem Herstellungsverfahren, das erheblich einfacher als bisherige Herstellungsverfahren ist.

Im folgenden werden Ausführungsbeispiele der Erfindung anhand der beiliegenden Zeichnungen erläutert. Darin zeigen:
Figur 1 einen Sensorchip mit zweihundertsechsundfünfzig Sensorelementen,
Figur 2 eine vergrößerte Darstellung eines Ausschnitts des Sensorchips,
Figur 3 den Sensorchip mit einem Szintillatorblock,
Figur 4 den Sensorchip am Ende des Herstellungsverfahrens, und
Figuren 5A bis 5I ausgewählte Herstellungsstufen des Sensorchips.

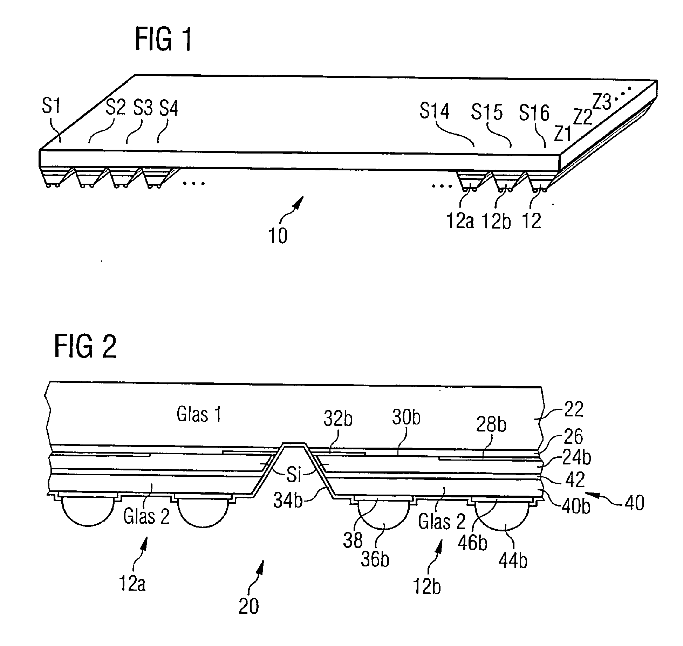

Figur 1 zeigt eine Prinzipdarstellung eines Sensorchips 10, der zweihundertsechsundfünfzig Sensorelemente 12, 12a, 12b enthält, die alle den gleichen Aufbau haben sich jedoch in den lateralen Abmessungen unterscheiden können. Die Sensorelemente 12, 12a, 12b sind matrixförmig in sechzehn Zeilen Z1 bis Z16 und in sechzehn Spalten S1 bis S16 angeordnet.
Figur 2 zeigt eine vergrößerte Darstellung eines Ausschnitts 20 des Sensorchips 10 mit zwei Sensorelementen 12a und 12b. Die Sensorelemente 12a und 12b werden von einer Glasscheibe 22 gehalten. Der Aufbau eines Sensorelementes wird im folgenden anhand des Sensorelementes 12b erläutert.

Das Sensorelement 12b enthält in einer Waferschicht 24 einen Waferbereich 24b, der mit Hilfe einer Klebeschicht 26, z.B. aus Epoxidharz, an der Glasscheibe 22 angeklebt ist. Der Waferbereich 24b enthält Silizium und dotierte Bereiche einer pin-Diode 28. Eine Leitbahn 30b erstreckt sich von einem Anschluss der Diode 28 zu einer Anschlussfläche 32b am Rand des Waferbereiches 24b. Eine äußere Leitbahn 34b stellt eine elektrisch leitende Verbindung zwischen der Anschlussfläche 32b und einer Lötkugel 36 auf einer Kontaktierungsfläche 38 her.

An der der Glasscheibe 28 abgewandten Seite des Waferbereiches 24 befindet sich ein Glasscheibenbereich 40, der mit Hilfe einer Klebeschicht 42 an den Waferbereich 24 angeklebt ist.

Das Sensorelement 12b enthält außer dem Lotkügelchen 36b ein weiteres Lotkügelchen 44 aus einem weichlötbaren Lot auf einer Kontaktfläche 46b. Damit gibt es zwei Anschlüsse zum Sensorelement 12b, beispielsweise für einen Masseanschluss und für einen Signalanschluss.

Im Ausführungsbeispiel enthält das Sensorelement 12b und auch die anderen Sensorelemente 12, 12a neben der pin-Diode keine weiteren Halbleiterbauelemente, insbesondere keine verstärkenden Bauelemente.

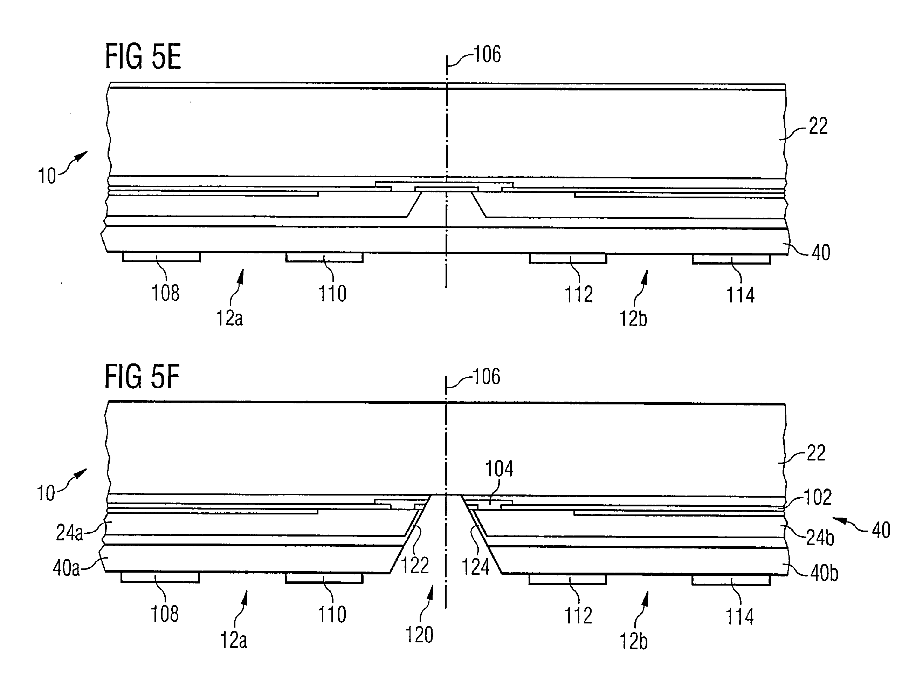

Verfahrensschritte zur Herstellung des in den Figuren 1 und 2 dargestellten Sensorchips 10 werden unten anhand der Figuren 5E bis 5I näher erläutert. Gemäß dem zuerst erläuterten Ausführungsbeispiel werden die Sensorchips 10 eines Wafers vereinzelt, bevor ein sogenannter Szintillatorblock am Sensorchip befestigt wird.

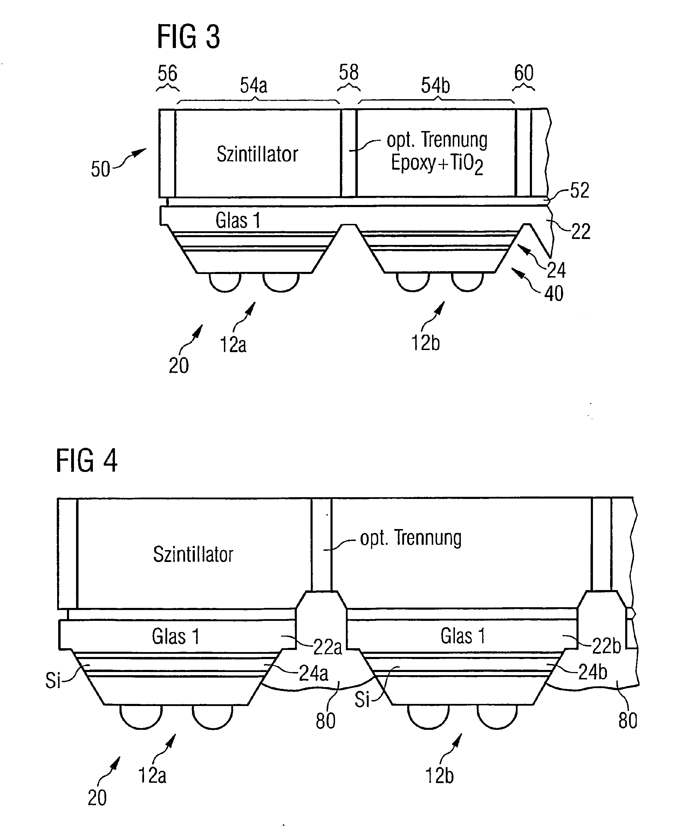

Figur 3 zeigt den Ausschnitt 20 des Sensorchips 10 mit einem Szintillatorblock 50, der mit Hilfe einer Klebeschicht 52 an der freien Seite der Glasscheibe 22 angeklebt ist. Die Klebeschicht 52 ist beispielsweise eine Epoxidharzschicht.

Im Ausführungsbeispiel enthält der Szintillatorblock 50 Bereiche 54a und 54b, die Röntgenstrahlung in sichtbares Licht umwandeln und die jeweils einem Sensorelement 12a bzw. 12b zugeordnet sind. Zwischen den Bereichen 54a, 54b liegen reflektierende Bereiche 56a bis 60, die sichtbares Licht in die Bereiche 54a, 54b reflektieren, um die Empfindlichkeit des Sensors zu erhöhen.

Nach dem Aufkleben des Szintillatorblockes 50 auf die Glasscheibe 22 ist die Glasscheibe 22 noch zwischen benachbarten Sensorelementen 12a und 12b eines Sensorchips 10 durchgehend. Figur 4 zeigt den Ausschnitt 20 nach dem Durchsägen der Glasscheibe 22 in Bereichen zwischen den Sensorelementen 12a und 12b. Durch das Sägen sind aus der Glasscheibe 22 zwei Glasscheibenbereiche 22a bzw. 22b entstanden, die zum Sensorelement 12a bzw. 12b gehören. Der Szintillatorblock 50 wurde beim Sägen nur angesägt, jedoch nicht durchtrennt.

Nach dem Sägen wurden die Bereiche zwischen den Glasscheibenbereichen 22a und 22b sowie zwischen den Waferbereichen 24a und 24b mit einem Füllmaterial 80 aufgefüllt, beispielsweise mit einem Epoxidharz, das mit Titandioxid versetzt worden ist.

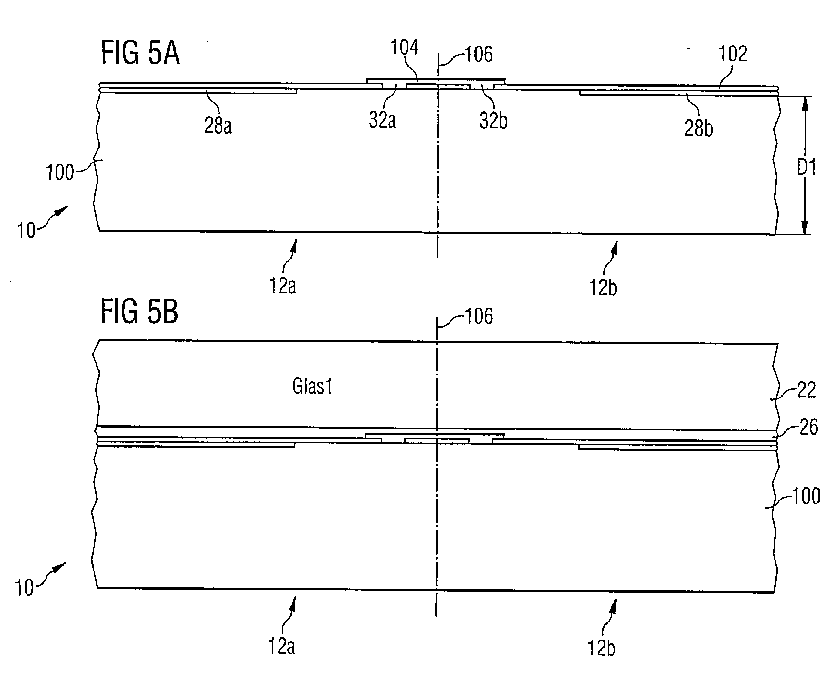

Figur 5A zeigt eine Herstellungsstufe des Sensorchips 10 nach dem Herstellen der pin-Dioden 28a, 28b auf einem Halbleiterwafer 100, der eine Dicke D1 von beispielsweise 650 oder 750 Mikrometern hat. Nach der Herstellung der pin-Dioden 28a, 28b wurde eine Passivierungsschicht 102 ganzflächig aufgebracht, beispielsweise eine Siliziumnitritschicht. Zu Anschlussflächen 32a und 32b wurde mit Hilfe eines photolithographischen Verfahrens danach in der Passivierungsschicht 102 Aussparungen erzeugt.

Anschließend wird eine Metallisierungsschicht 104 aufgebracht und strukturiert. Dabei entstanden elektrisch leitfähige Verbindungen von den gefüllten Aussparungen zu Randbereichen der Sensorelemente 12a, 12b.

In den Figuren 5A bis 5I verdeutlicht eine Strichpunktlinie eine Grenze 106 zwischen den Sensorelementen 12a und 12b.

Wie in Figur 5B gezeigt, wurde danach die Glasscheibe 22 aufgeklebt. Im Ausführungsbeispiel hat die Glasscheibe 22 beispielsweise eine Dicke von 400 Mikrometern, so dass sie mechanisch vergleichsweise stabil ist.

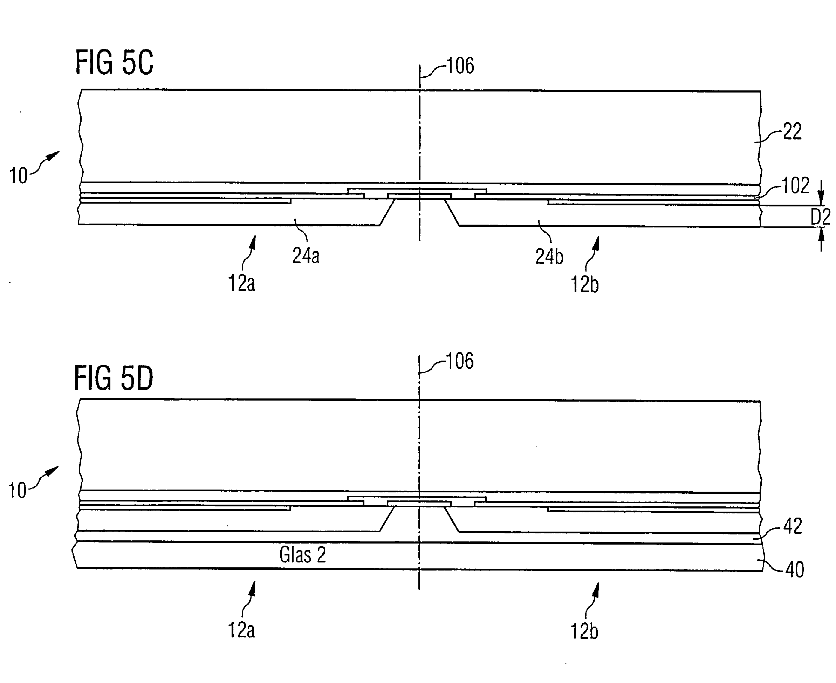

Figur 5C zeigt den Sensorchip 10 nach einem Dünnschleifprozess oder einem Atzprozess, bei dem Dicke D1 des Halbleiterwafers 100 um mindestens die Hälfte der Dicke D1 auf eine Dicke D2 verringert worden ist, die im Ausführungsbeispiel fünfzig Mikrometer beträgt. Nach dem Dünnen werden die einzelnen Chips 10 und auch die einzelnen Waferbereiche 24a, 24b mit Hilfe eines Ätzprozesses, beispielsweise mit Hilfe eines nasschemischen Ätzprozesses, getrennt. Es wird bspw. selektiv zur Passivierungsschicht 102 geätzt.

Figur 5D zeigt den Sensorchip 10 nach dem Aufkleben der Glasscheibe 40 mit Hilfe der Klebeschicht 42. Die Klebeschicht 40 besteht, wie bereits erwähnt, bspw. ebenfalls aus Epoxidharz oder einem anderen geeigneten Klebemittel.

Figur 5E zeigt den Sensorchip 10 nach dem Aufbringen von Lötpads 108 bis 114 auf die Glasplatte 40. bspw. tragen die Lötpads 112 und 114 die Kontaktflächen 38 und 40.

Wie in Figur 5F dargestellt, wird anschließend die Glasplatte 40 mit Hilfe eines V-förmigen Schnittes 120 an der Grenze 106 zersägt, wobei auf der Glasscheibe 40 die Glasscheibenbereiche 40a und 40b erzeugt werden. Der Schnitt 120 erstreckt sich bis in die Glasplatte 22 und durchtrennt damit sowohl die Passivierungsschicht 102 als auch die Metallisierungsschicht 104 im Bereich der Grenze 106. Zwischen den Waferbereichen 24a und 24b sowie zwischen den Seitenflächen des Schnittes 120 verbleiben mit Epoxidharz gefüllte Bereiche 122 bzw. 124, welche u.a. die Herstellung einer leitenden Verbindung zu den Lötpads 108, 110 bzw. 112, 114 erleichtert.

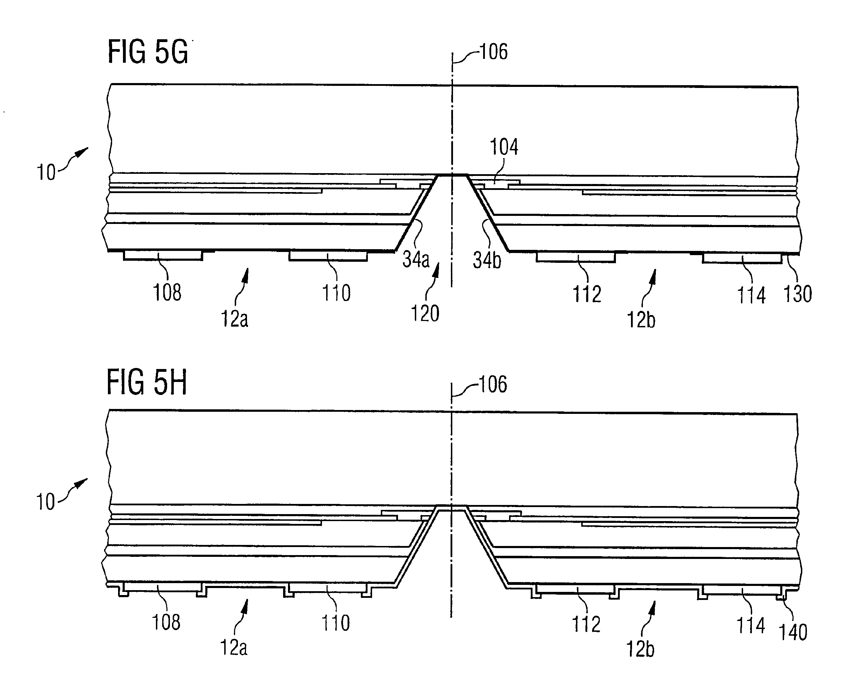

Wie in Figur 5G gezeigt, wird anschließend auf der Rückseite des Sensorchips 10 eine Metallisierungsschicht 130 aufgebracht und strukturiert, wobei die äußeren Leitbahnen 34a und 34b erzeugt werden. Abschnitte der äußeren Leitbahnen 34a und 34b verlaufen an den Seitenwänden des Schnittes 120, so daß auch Leitbahnen in der Metallisierungsschicht 104 kontaktiert werden, die bis zum Schnitt 120 reichen.

Figur 5H zeigt eine Prozessstufe bei der Herstellung des Sensorchips 10 nach dem Aufbringen einer Passivierungsschicht 140 auf die Rückseite des Sensorchips 10. Die Passivierungsschicht 140 wird in einem folgenden Verfahrensschritt im Bereich der Lötpads 108 bis 114 strukturiert, so dass die Lötpads 108 bis 114 freigelegt werden.

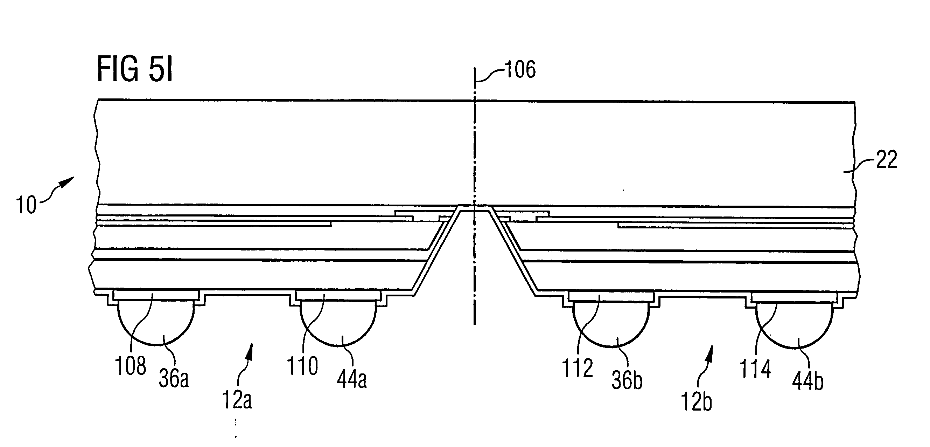

Wie in Figur 5I gezeigt, werden anschließend die Lötkügelchen 36a, 44a, 36b und 44b auf die Lötpads 108 bis 114 aufgebracht, wobei die Passivierungsschicht 140 als Maske wirkt.

Nach der in Figur 5I gezeigten Herstellungsstufe werden beim ersten Ausführungsbeispiel die Sensorchips 10 vereinzelt und erst dann mit den Szintillatorblöcken 50 verbunden, siehe Erläuterungen zu den Figuren 3 und 4. Beim Vereinzeln der Sensorchips 10 wird die Glasscheibe 22 an den Chipgrenzen getrennt, nicht aber zwischen den Sensorelementen 12a, 12b eines Sensorelements 10.

Bei einem anderen Ausführungsbeispiel werden die Szintillatorblöcke 50 vor dem Vereinzeln der Chips auf die Glasscheibe 22 aufgeklebt. Danach wird die Glasscheibe 22 zwischen den Sensorelementen 12a, 12b eines Sensorchips 10 zertrennt, wobei die Szintillatorblöcke 50 noch nicht durchtrennt werden. Erst in einem folgenden Verfahrensschritt werden dann an den Chipgrenzen sowohl die Glasscheibe 22 als auch die Szintillatorblöcke 50 getrennt.

Bei einem nächsten Ausführungsbeispiel wird von der anhand der Figuren 5A bis 5I erläuterten Abfolge der Verfahrensschritte abgewichen. Beispielsweise läßt sich der Schnitt 120 vor dem Aufbringen der Lötpads 108 bis 114 durchführen. Der Schnitt 120 läßt sich auch tiefer oder breiter als erläutert ausführen, so dass auch in den Bereichen 122, 124 das Klebematerial entfernt wird.

Enthalten die Sensorelemente jeweils nur eine pin-Diode, so gibt es keine Technologieunterschiede, wie sie bei der Integration von Verstärkerelementen in den Sensorchip auftreten. Dadurch verringern sich die Prozesskosten pro Flächenabschnitt mit Fotodioden erheblich.

Die Anordnung der Anschlüsse auf der Rückseite führt zu einer kleineren Chipfläche in lateraler Richtung. Außerdem gibt es für die Anschlüsse ausreichend Platz auf der Rückseite, so dass die Abmessungen der Anschlüsse großzügiger gewählt werden können. Die Anordnung der Anschlüsse auf der Rückseite ermöglicht auch eine einfachere Montage des Szintillatorblocks.

Das Bilden von Waferbereichen verhindert auch ein Übersprechen zwischen den Halbleiterbauelementen verschiedener Sensorelemente.

Durch die erläuterten Anordnung kann die volle Länge eines Sensorelementes für die Metallverbindung zwischen der Oberseite der Waferbereiche und den Lotkügelchen genutzt werden.

Bei einem anderen Ausführungsbeispiel werden mehr als zwei Anschlüsse pro Sensorelement hergestellt.

## Patentansprüche

1. Sensoranordnung (10) zum Erfassen einer Strahlung mit einer Schichtenfolge, die in der angegebenen Reihenfolge enthält:
ein Haltesubstrat (50), das zumindest bereichsweise für die zu erfassende Strahlung durchlässig ist oder beim Auftreffen einer Strahlung eine zu erfassende Strahlung erzeugt, und das mehrere Erfassungselemente (12a, 12b) der Sensoranordnung (10) hält,
mindestens eine Hilfsschicht (22), die für die zu erfassende Strahlung durchlässig ist und die sich durchgehend über mehrere Erfassungselemente (12a, 12b) erstreckt oder die voneinander getrennte Bereiche (22a, 22b) enthält, die jeweils einem Erfassungselement (12a,12b) zugeordnet sind,
eine Erfassungsschicht (24) mit voneinander getrennten und in einem Erfassungselement (12a, 12b) enthaltenen Erfassungsbereichen (24a, 24b) in denen jeweils mindestens ein für die zu erfassende Strahlung sensitives Halbleiterbauelement (28b) angeordnet ist,
und eine Isolierschicht (40) mit voneinander getrennten Isolierbereichen (40b) zum elektrischen Isolieren der Erfassungsbereiche (24b) von einer Kontaktierungslage mit elektrisch leitfähigen Anschlüssen (36) und mit an der freien Seite angebrachten Anschlussflächen (108 bis 114),
wobei die Anschlussflächen (108 bis 114) mit Anschlussstellen (104), die zu den Halbleiterbauelementen (28a, 28b) führen, elektrisch verbunden sind,
und wobei das Haltesubstrat (50) ein Material enthält, das eine auftreffende Teilchenstrahlung oder eine im Vergleich zu der zu erfassenden Strahlung energiereiche Strahlung in die zu erfassende Strahlung umwandelt.

2. Sensoranordnung (10) nach Anspruch 1, **dadurch gekennzeichnet, dass** das Haltesubstrat (50) für die zu erfassende Strahlung durchlässige Bereiche (54a, 54b) enthält, die jeweils in einem Erfassungselement (12a, 12b) enthalten sind, und
dass das Haltesubstrat (50) die zu erfassende Strahlung absorbierende oder reflektierende Bereiche (56 bis 60) zwischen den Erfassungselementen (12a, 12b) enthält.

3. Sensoranordnung (10) nach Anspruch 1 oder 2, **dadurch gekennzeichnet, dass** das Haltesubstrat (50) ein Material enthält, das eine Röntgenstrahlung in eine mit einer pin-Diode (28b) erfassbare Strahlung umwandelt, vorzugsweise ein gut absorbierendes Halbleitermaterial oder CdZnTe oder PbO, oder GaOSulfid.

4. Sensoranordnung (10) nach einem der vorhergehenden Ansprüche, **dadurch gekennzeichnet, dass** die Bereiche (22a, 22b) der Hilfsschicht (22) und/oder die Erfassungsbereiche (24a, 24b) und/oder die Isolierbereiche (40a,40b) durch ein Füllmaterial (80) getrennt sind,
und/oder dass das Füllmaterial (80) ein Kunststoff, vorzugsweise ein Epoxydharz ist,
und/oder dass das Füllmaterial (80) mit einem die zu erfassende Strahlung absorbierenden oder reflektierenden Material versetzt ist, vorzugsweise mit Titandioxid.

5. Sensoranordnung (10) nach einem der vorhergehenden Ansprüche, **dadurch gekennzeichnet, dass** die Hilfsschicht (22) eine Glasschicht oder eine Keramikschicht ist,
und/oder dass die Isolierschicht (40) eine Glasschicht ist,
und/oder dass die Erfassungsschicht (24) ein HalbleiterTrägermaterial enthält, vorzugsweise ein Siliziummaterial und/oder ein gedünntes Siliziummaterial,
und/oder dass die Kontaktierungslage Lötmaterial (36) enthält.

6. Sensoranordnung (10) nach einem der vorhergehenden Ansprüche, **dadurch gekennzeichnet, dass** eine Erfassungsfläche der Erfassungselemente (12a, 12b) kleiner als fünf Quadratmillimeter oder kleiner als ein Quadratmillimeter ist,
und/oder dass die Sensoranordnung (10) mehr als zweihundert Erfassungselemente (12a, 12b) enthält.

7. Sensoranordnung (10) nach einem der vorhergehenden Ansprüche, **dadurch gekennzeichnet, dass** die Halbleiterbauelemente (28a, 28b) einen dotierten Bereich eines Leitungstyps, einen dotierten Bereiche eines anderen Leitungstyps und einen zwischen diesen Bereichen liegenden undotierten oder im Vergleich zur Dotierung der anderen Bereiche mit einer schwachen Dotierung versehenen Zwischenbereich enthält.

8. Computertomograph,
mit einer Strahlungssendeeinheit zum Aussenden einer Strahlung, vorzugsweise einer Röntgenstrahlung,
mit einer Erfassungseinheit (10) zum Erfassen der ausgesendeten Strahlung nach dem Durchtritt durch ein die Strahlungsintensität beeinflussendes Gewebe,
und mit einer Auswerteeinheit, die abhängig von den Ausgangssignalen der Erfassungseinheit Bilddaten eines Bildes der Struktur des Gewebes erzeugt,
**dadurch gekennzeichnet, dass** die Erfassungseinheit eine Sensoranordnung (10) nach einem der vorhergehenden Ansprüche enthält.

9. Verfahren zum Herstellen einer Sensoranordnung (10),
bei dem die folgenden Schritte ausgeführt werden:
Herstellen einer Vielzahl integrierter strahlungsempfindlicher Halbleiterbauelemente (28a, 28b) ausgehend von einem Trägersubstrat (100) aus Halbleitermaterial einer Ausgangsdicke (D1),
mechanisches Verbinden des Trägersubstrats (100) und eines Hilfssubstrats (22) an einer Seite des Trägersubstrats, welche strahlungsempfindliche Flächen der Halbleiterbauelemente (28a, 28b) enthält, wobei das Hilfssubstrat (22) für die zu erfassende Strahlung durchlässig ist,
Dünnen des Trägersubstrats (100) an der freiliegenden Seite auf eine Dicke (D2), die kleiner als die Ausgangsdicke (D1) ist,
mechanisches Verbinden der freien Seite des Trägersubstrats (100) mit einem Isoliersubstrat (40),
Anbringen von Anschlussflächen (108 bis 114) an der freien Seite des Isoliersubstrats (40),
Trennen des Isoliersubstrats an den Grenzen einzelner Halbleiterplättchen mit einer Vielzahl von Halbleiterbauelementen (28a, 28b) und/oder an den Grenzen einzelner Halbleiterbauelemente (28b, 28b), wobei das Hilfssubstrat (22) nicht getrennt wird,
elektrisches Verbinden der Anschlussflächen (108 bis 114) mit Anschlussstellen (104), die zu den Halbleiterbauelementen (28a, 28b) führen,
mechanisches Verbinden des Hilfssubstrates (22) und eines Haltesubstrates (50) an der freiliegenden Seite des Hilfssubstrates (22), wobei das Haltesubstrat (50) eine auftreffende Teilchenstrahlung oder eine im Vergleich zu einer zu erfassenden Strahlung energiereiche Strahlung in die zu erfassende Strahlung umwandelt,
Trennen des Hilfssubstrates (22) an den Grenzen einzelner Halbleiterplättchen und/oder einzelner Halbleiterbauelemente (28a, 28b), wobei das Hilfssubstrat (50) nicht getrennt wird.

10. Verfahren nach Anspruch 9, **gekennzeichnet durch** den Schritt:
Trennen des gedünnten Trägersubstrates (100) an den Grenzen einzelner Halbleiterplättchen mit einer Vielzahl von Halbleiterbauelementen (28a, 28b) und/oder an den Grenzen einzelner Halbleiterbauelemente (28a, 28b), wobei das Hilfssubstrat (22) nicht getrennt wird und wobei mindestens eine Leitbahn einer Metallisierungslage der Halbleiterbauelemente (28a, 28b) an einer Anschlussstelle (104) freigelegt wird,
wobei das Trennen des gedünnten Trägersubstrats (100) vorzugsweise vor dem mechanischen Verbinden der freien Seite des Trägersubstrates (100) mit dem Isoliersubstrat (40) ausgeführt wird.

11. Verfahren nach Anspruch 9 oder 10, **gekennzeichnet durch** den Schritt :
Füllen der Trennstelle (120) mit einem Füllmaterial (80).

## Claims

1. Sensor arrangement (10) for detecting radiation having a layer sequence which contains, in the order indicated:
a holding substrate (50) which is permeable to the detectable radiation, at least in regions, or produces detectable radiation when radiation impinges and which holds a plurality of detection elements (12a, 12b) in the sensor arrangement (10),
at least one auxiliary layer (22) which is permeable to the detectable radiation and extends continuously over a plurality of detection elements (12a, 12b) or which contains separate regions (22a, 22b) which are respectively associated with a detection element (12a, 12b),
a detection layer (24) with separate detection regions (24a, 24b) which are contained in a detection element (12a, 12b) and respectively contain at least one semiconductor component (28b) which is sensitive to the detectable radiation,
and an insulating layer (40) with separate insulating regions (40b) for electrically insulating the detection regions (24b) from a point of contact having electrically conductive connections (36) and having pads (108 to 114) fitted on the free side, the pads (108 to 114) being electrically connected to connecting points (104) which are routed to the semiconductor components (28a, 28b),
and the holding substrate (50) containing a material which converts impinging particle radiation or radiation which is high in energy as compared with the detectable radiation into the detectable radiation.

2. Sensor arrangement (10) according to Claim 1, **characterized in that** the holding substrate (50) contains regions (54a, 54b) which are permeable to the detectable radiation and are respectively contained in a detection element (12a, 12b), and
**in that** the holding substrate (50) contains, between the detection elements (12a, 12b), regions which absorb or reflect the detectable radiation.

3. Sensor arrangement (10) according to Claim 1 or 2, **characterized in that** the holding substrate (50) contains a material which converts X-ray radiation into radiation which can be detected with a pin diode (28b), preferably a highly absorbent semiconductor material or CdZnTe or PbO, or GaO sulfide.

4. Sensor arrangement (10) according to one of the preceding claims, **characterized**
**in that** the regions (22a, 22b) of the auxiliary layer (22) and/or the detection regions (24a, 24b) and/or the insulating regions (40a, 40b) are separated by a filling material (80),
and/or in that the filling material (80) is a plastic, preferably an epoxy resin,
and/or in that the filling material (80) has been mixed with a material which absorbs or reflects the detectable radiation, preferably with titanium dioxide.

5. Sensor arrangement (10) according to one of the preceding claims, **characterized**
**in that** the auxiliary layer (22) is a glass layer or a ceramic layer,
and/or in that the insulating layer (40) is a glass layer,
and/or in that the detection layer (24) contains a semiconductor support material, preferably a silicon material and/or a thinned silicon material,
and/or in that the point of contact contains solder material (36).

6. Sensor arrangement (10) according to one of the preceding claims, **characterized**
**in that** a detection area on the detection elements (12a, 12b) is smaller than five square millimeters or smaller than one square millimeter,
and/or in that the sensor arrangement (10) contains more than two hundred detection elements (12a, 12b).

7. Sensor arrangement (10) according to one of the preceding claims, **characterized**
**in that** the semiconductor components (28a, 28b) contain a doped region of one conduction type, a doped region of another conduction type and, between these regions, an intermediate region which is undoped or is provided with a weak doping as compared with the doping of the other regions.

8. Computer tomograph,
having a radiation transmission unit for emitting radiation, preferably X-ray radiation,
having a detection unit (10) for detecting the emitted radiation following the passage through a tissue which influences the radiation intensity,
and having an evaluation unit which takes the output signals from the detection unit as the basis for producing image data for an image of the structure of the tissue,
**characterized in that** the detection unit contains a sensor arrangement (10) according to one of the preceding claims.

9. Method for manufacturing a sensor arrangement (10),
in which the following steps are performed:
a large number of integrated radiation-sensitive semiconductor components (28a, 28b) are manufactured starting from a support substrate (100) made of semiconductor material of an initial thickness (D1),
the support substrate (100) and an auxiliary substrate (22) are mechanically connected on one side of the support substrate, which side contains radiation-sensitive areas of the semiconductor components (28a, 28b), with the auxiliary substrate (22) being permeable to the detectable radiation,
the support substrate (100) is thinned on the bare side to a thickness (D2) which is less than the initial thickness (D1),
the free side of the support substrate (100) is mechanically connected to an insulating substrate (40),
pads (108 to 114) are put on the free side of the insulating substrate (40),
the insulating substrate is separated at the boundaries between individual semiconductor boards having a large number of semiconductor components (28a, 28b) and/or at the boundaries between individual semiconductor components (28a, 28b), with the auxiliary substrate (22) not being separated,
the pads (108 to 114) are electrically connected to connecting points (104) which lead to the semiconductor components (28a, 28b),
the auxiliary substrate (22) and a holding substrate (50) are mechanically connected on the bare side of the auxiliary substrate (22), with the holding substrate (50) converting impinging particle radiation or radiation which is high in energy as compared with detectable radiation into the detectable radiation,
the auxiliary substrate (22) is separated at the boundaries between individual semiconductor boards and/or individual semiconductor components (28a, 28b), with the holding substrate (50) not being separated.

10. Method according to Claim 9, **characterized by** the following step:
the thinned support substrate (100) is separated at the boundaries between individual semiconductor boards having a large number of semiconductor components (28a, 28b) and/or the boundaries between individual semiconductor components (28a, 28b), with the auxiliary substrate (22) not being separated and with at least one interconnect in a metallization layer of the semiconductor components (28a, 28b) being exposed at a connecting point (104),
the thinned support substrate (100) preferably being separated before the free side of the support substrate (100) is mechanically connected to the insulating substrate (40).

11. Method according to Claim 9 or 10, **characterized by** the following step:
the separation point (120) is filled with a filling material (80).

## Revendications

1. Dispositif (10) de capteur pour détecter un rayonnement, comprenant une succession de couches, qui comporte dans l'ordre indiqué :
un substrat (50) de maintien, qui est, au moins par endroit, transparent au rayonnement à détecter ou qui produit, lors de l'incidence d'un rayonnement, un rayonnement à détecter et qui maintient plusieurs éléments (12a, 12b) de détection du dispositif (10) de capteur,
au moins une couche (22) auxiliaire, qui est transparente au rayonnement à détecter et qui s'étend d'une manière continue sur plusieurs éléments (12a, 12b) de détection ou qui comporte des zones (22a, 22b) séparées les unes des autres et associées respectivement à un élément (12a, 12b) de détection,
une couche (24) de détection ayant des zones (24a, 24b) de détection, qui sont séparées les unes des autres, qui sont contenues dans un élément (12a, 12b) de détection et dans lesquelles est disposé respectivement au moins un composant (28b) à semiconducteur sensible au rayonnement à détecter,
et une couche (40) isolante ayant des zones (40b) isolantes séparées les unes des autres pour isoler électriquement les zones (24b) de détection d'une strate de mise en contact ayant des bornes (36) conductrices de l'électricité et ayant des surfaces (108 à 114) de connexion mises sur la face libre,
dans lequel les surfaces (108 à 114) de connexion sont reliées électriquement à des points (104) de connexion qui mènent aux composants (28a, 28b) à semiconducteur,
et dans lequel le substrat (50) de maintien contient un matériau, qui transforme un rayonnement de particules incident ou un rayonnement riche en énergie par rapport au rayonnement à détecter en le rayonnement à détecter.

2. Dispositif (10) de capteur suivant la revendication 1, **caractérisé en ce que** le substrat (50) de maintien comporte des zones (54a, 54b) transparentes au rayonnement à détecter et contenues respectivement dans un élément (12a, 12b) de détection, et
**en ce que** le substrat (50) de maintien contient entre les éléments (12a, 12b) de détection des zones (56 à 60) absorbant ou réfléchissant le rayonnement à détecter.

3. Dispositif (10) de capteur suivant la revendication 1 ou 2, **caractérisé en ce que** le substrat (50) de maintien contient un matériau, qui transforme un rayonnement X en un rayonnement pouvant être détecté par une diode pin (28b), de préférence un matériau semiconducteur absorbant ou du sulfure de GaO.

4. Dispositif (10) de capteur suivant l'une des revendications précédentes, **caractérisé en ce que** les zones (22a, 22b) de la couche (22) auxiliaire et/ou des zones (24a, 24b) de détection et/ou les zones (40a, 40b) isolantes sont séparées par un matériau (80) de remplissage, et/ou **en ce que** le matériau (80) de remplissage est une matière plastique, de préférence une résine époxyde,
et/ou **en ce que** le matériau (80) de remplissage est mélangé à un matériau absorbant ou réfléchissant le rayonnement à détecter, de préférence à du dioxyde de titane.

5. Dispositif (10) de capteur suivant l'une des revendications précédentes, **caractérisé en ce que** la couche (22) auxiliaire est une couche de verre ou une couche de céramique,
et/ou **en ce que** la couche (40) isolante est une couche de verre,
et/ou **en ce que** la couche (24) de détection contient un matériau support semiconducteur, de préférence un matériau en silicium et/ou un matériau en silicium aminci,
et/ou **en ce que** la strate de mise en contact contient du matériau (36) de brasure.

6. Dispositif (10) de capteur suivant l'une des revendications précédentes, **caractérisé en ce qu'**une surface de détection des éléments (12a, 12b) de détection est plus petite que cinq millimètres carré ou plus petite qu'un millimètre carré,
et/ou **en ce que** le dispositif (10) de capteur contient plus de deux cents éléments (12a, 12b) de détection.

7. Dispositif (10) de capteur suivant l'une des revendications précédentes, **caractérisé en ce que** les composants (28a, 28b) à semiconducteur contiennent une zone dopée d'un type de conductivité, une zone dopée d'un autre type de conductivité et une zone intermédiaire entre ces zones, qui n'est pas dopée ou qui est pourvue d'un dopage faible par rapport au dopage des autres zones.

8. Tomographe informatique,
comprenant une unité d'émission de rayonnement, pour émettre un rayonnement, de préférence un rayonnement X,
comprenant une unité (10) de capteur, pour la détection du rayonnement émis après qu'il a traversé un tissu influençant l'intensité du rayonnement,
et comprenant une unité d'exploitation, qui, en fonction des signaux d'entrée de l'unité de détection, produit des données d'image d'une image de la structure du tissu,
**caractérisé en ce que** l'unité de détection comporte un dispositif (10) de capteur suivant l'une des revendications précédentes.

9. Procédé de fabrication d'un dispositif (10) de capteur, dans lequel on effectue les stades suivantes :
on fabrique une pluralité de composants (28a, 28b) à semiconducteur intégrés et sensibles au rayonnement en partant d'un substrat (100) formant support en un matériau semiconducteur d'une épaisseur (D1) de départ,
on relie mécaniquement le substrat (100) formant support et un substrat (22) auxiliaire sur une face du substrat formant support, lequel comporte des surfaces sensibles au rayonnement des composants (28a, 28b) à semiconducteur, le substrat (22) auxiliaire étant transparent au rayonnement à détecter,
on amincit le substrat (100) formant support sur la face libre jusqu'à une épaisseur (D2), qui est plus petite que l'épaisseur (D1) de départ,
on relie mécaniquement la face libre du substrat (100) formant support à un substrat (40) isolant,
on ménage des surfaces (108 à 114) de connexion sur la face libre du substrat (40) isolant,
on sépare le substrat isolant aux limites de plaquettes individuelles de semiconducteur ayant une pluralité de composants (28a, 28b) à semiconducteur et/ou aux limites de composants (28b, 28b) à semiconducteur individuels, le substrat (22) auxiliaire n'étant pas séparé,
on relie électriquement les surfaces (108 à 114) de connexion à des points (104) de connexion, qui mènent aux composants (28a, 28b) à semiconducteur,
on relie mécaniquement le substrat (22) auxiliaire et un substrat (50) de maintien sur la face libre du substrat (22) auxiliaire, le substrat (50) de maintien transformant un rayonnement de particules incident ou un rayonnement riche en énergie par rapport à un rayonnement à détecter en le rayonnement à détecter,
on sépare le substrat (22) auxiliaire aux limites des plaquettes à semiconducteur individuelles et/ou des composants (28a, 28b) à semiconducteur individuels, le substrat (50) auxiliaire n'étant pas séparé.

10. Procédé suivant la revendication 9, **caractérisé par** le stase :
on sépare le substrat (100) aminci formant support aux limites de plaquettes à semiconducteur individuelles ayant une pluralité de composants (28a, 28b) à semiconducteur et/ou aux limites de composants (28a, 28b) à semiconducteur individuels, le substrat (22) auxiliaire n'étant pas séparé et au moins une piste conductrice d'une strate de métallisation des composants (28a, 28b) à semiconducteur étant mise à nu en un point (104) de connexion, la séparation du substrat (100) aminci formant support étant effectuée, de préférence avant la liaison mécanique de la face libre du substrat (100) formant support au substrat (40) isolant.

11. Procédé suivant la revendication 9 ou 10, **caractérisé par** le stase :
on remplit le point (120) de séparation d'un matériau (80) de remplissage.
